Europäisches Patentamt

European Patent Office

Office européen des brevets

(19)

(11) Publication number : **0 456 372 B1**

(12) **EUROPEAN PATENT SPECIFICATION**

(45) Date of publication of patent specification :
22.03.95 Bulletin 95/12

(51) Int. Cl.⁶ : **H01L 21/00**

(21) Application number : **91303628.1**

(22) Date of filing : **23.04.91**

(54) **Perimeter wafer seal with gas exclusion.**

(30) Priority : **23.04.90 US 512809**

(43) Date of publication of application :
**13.11.91 Bulletin 91/46**

(45) Publication of the grant of the patent :
**22.03.95 Bulletin 95/12**

(84) Designated Contracting States :
**DE FR GB IT NL**

(56) References cited :
FR-A- 2 566 682
US-A- 4 542 298
US-A- 4 932 358

(73) Proprietor : **GENUS, INC.**
**515 Ellis Street**
**Mt. View California 94043 (US)**

(72) Inventor : **Schmitz, John**
**939 Arlington Court**
**Sunnyvale, California 94087 (US)**
Inventor : **Chow, Raymond L.**
**20693 Greenleaf Drive**
**Cupertino, California 95014 (US)**
Inventor : **Scholz, Frederick J.**
**2035 Dickens Court**
**Fremont, California 94536 (US)**
Inventor : **Turner, Norman L.**
**44 Riverview Road**
**Gloucester, Massachusetts 01930 (US)**
Inventor : **Uher, Frank Otto**
**1221 Richardson**
**Los Altos, California 94042 (US)**

(74) Representative : **Wright, Peter David John et al**
**R.G.C. Jenkins & Co.**
**26 Caxton Street**
**London SW1H 0RJ (GB)**

## Description

The present invention is related to copending European patent application EP-A- 398589 entitled PERIMETER WAFER SEAL, by David K. Studley and Ernst Keller, which falls under Art. 54(3) EPC.

## Field of the Invention

The present invention pertains to apparatus for chemical vapor deposition (CVD) for production of integrated circuits, and relates in particular to apparatus and methods for excluding deposition on the backside and edges of wafers in such processes.

## Background of the Invention

The manufacturing of integrated circuits involves forming thin films and layers of various materials on wafers of a base semiconductor material, and then selectively removing areas of such films to provide structures and circuitry. Doped silicon is a typical base wafer material. CVD is a well known process for depositing such thin films and layers. For example, polysilicon may be deposited from silane gas, $SiH_4$. It is known, too, to deposit tungsten silicide from a mixture of gases including silane and a tungsten-bearing gas such as tungsten hexafluoride. Pure tungsten is also deposited on silicon wafers in the manufacture of integrated circuits, sometimes selectively and sometimes across the entire surface in a process known as "blanket" tungsten.

In a typical CVD process such as blanket tungsten, wafers are placed on supports within a vacuum chamber, the chamber is sealed and evacuated, the wafers are heated, typically by heating the wafer support, and a gas mixture is introduced into the chamber. For example, in the blanket tungsten process, tungsten hexafluoride and hydrogen are introduced as reactive gases, and typically argon is introduced as a non-reactive carrier gas. The tungsten hexafluoride is the source of deposited tungsten. Typically the gases are flowed continuously during process. The temperature of a substrate (wafer) to be coated is one of the variables that drives the chemical reaction to cause tungsten to be deposited on the substrate surface. It is important to control the temperature, the concentration of various gases in the mixture introduced, and such characteristics as the uniformity of flow of gas over the surface being coated, among other variables. A uniform thickness of a deposited layer is an important characteristic.

In most cases, active structures and circuitry are formed on one side of a wafer, and the other side is not used. The side not used is called the backside of the wafer. In lithography procedures for defining patterns on the deposited layers, the backside of a wafer is typically used as a registration surface. For this and other reasons it is important that the backside of a wafer be kept smooth and clean, and that material not be deposited on the backside.

Another important characteristic in layering techniques is that the deposited layers be adherent to the base wafer material or to the next underlying layer, so that the layered material doesn't flake or peel. The dimensions of structures and circuitry in integrated circuit technology are very small, so any unwanted flaking or peeling may easily cause particles that can spoil structures or circuitry. Moreover, flakes from non-adherent material can spoil structures and circuitry on other wafers, and also may damage sensitive equipment and require cleaning procedures beyond those that might otherwise be necessary.

Several techniques are employed to enhance adhesion of layers deposited by CVD. One is to deposit a thin layer of a material known as an adhesion layer or a glue layer. An adhesion layer in some cases is an entirely different material known to be adherent to the base material and to the material of a new layer to be applied. An adhesion layer is also sometimes applied in a separate process other than CVD. For example, titanium is in some cases deposited by sputtering as an adhesion layer before depositing tungsten or a tungsten-rich material, such as tungsten silicide, by chemical vapor deposition. Cleaning procedures, such as ion bombardment, are also used to prepare wafer surfaces to receive layers deposited by chemical vapor deposition.

For logistic reasons it is generally desirable to do pretreatment steps, such as ion cleaning, and to deposit adhesion layers while a wafer is mounted in the same chamber and upon the same apparatus that will be used to perform the chemical vapor deposition. Otherwise, the wafers to be coated have to be handled more often and must be mounted to and dismounted from different processing apparatus, which is time consuming and expensive, and increases the probability of damage, error, and contamination. Since the wafers are typically mounted in the CVD chamber with the backside against a support, only the frontside is presented to process steps designed to enhance adhesion. If only the frontside is cleaned or otherwise treated, the probability of subsequent coating on the backside or edge becomes greater.

As illustrated in the cross-referenced copending application, a perimeter wafer seal comprising a proximity seal can be used to avoid deposition on the backside or edge of a wafer during CVD processing.

The surface of wafers to be coated commonly exhibit a varying topography due to devices formed on the wafers, circuitry previously etched, and layers previously coated. These variations in topography are manifested typically in grooves (vias) and holes of varying depth in the surface, and it is important to be able to deposit films of relatively uniform thickness into such surface depressions, or in many cases, to fill the depressions completely.

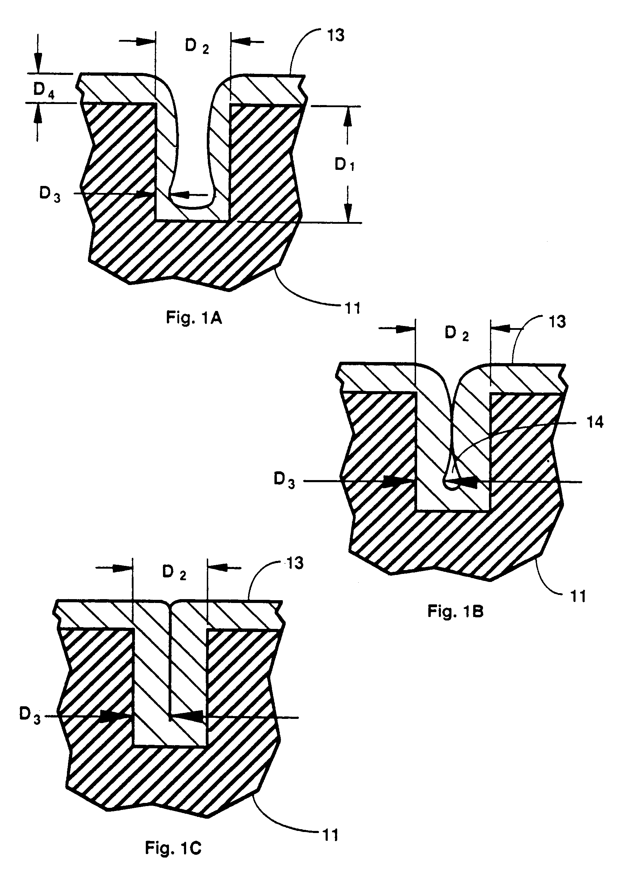

Figure 1A shows a section of a wafer 11 through an idealized via with a coating 13 to illustrate how coverage in vias and holes is quantified in the art. The severity of a via or hole is characterized by its Aspect Ratio (AR), and is the depth $D_1$ divided by the width $D_2$.

$$AR = D_1/D_2$$

Step coverage in a surface depression is quantified as a fraction or percentage determined by the minimum thickness $D_3$ of the film formed in the depression devided by the nominal thickness $D_4$ outside the via or hole. Typically, if coating conditions such as temperature and pressure remain constant, the step coverage degrades for most coating processes as the Aspect Ratio increases. Such degradation is more severe for line-of-sight processes like plasma sputtering than for CVD processes.

The trend of technical developments in the art of manufacturing integrated circuits is to greater and greater aspect ratio. One reason is that desirable increased density of devices and circuits on a single chip results in individual features being closer and closer together. Another reason is that manufacturers have developed multi-layering techniques wherein circuitry is built up, layer upon layer, to make efficient use of surface area, and deep vias must be etched so that electrically conductive layers can be deposited to connect devices in different layers.

As device dimensions have decreased to typical dimensions under one micrometer, the coating thickness requirements have not decreased proportionately. The result is a situation depicted by Fig. 1B. Narrower and deeper depressions in the topography of a wafer, without decreasing coating thickness, causes closing of the depression by the coating. The situation shown in Fig. 1B is but one of many possibilities, and illustrates a serious flaw that can result. The closing of the depression by the coating can leave a pocket 14 beneath the closed coating surface. The pocket is generally detrimental to function and reliability. Hole filling is quantified by the decimal or percentage:

$$2 \times D3/D2.$$

Unity, i.e. 1, or 100% represents complete hole filling.

Fig. 1C shows a situation similar to that of Fig. 1B, except the depression has been completely filled, leaving no trapped pocket below the surface. Complete hole filling as shown in Fig. 1C is the only acceptable condition for reliable process when hole filling is required at all.

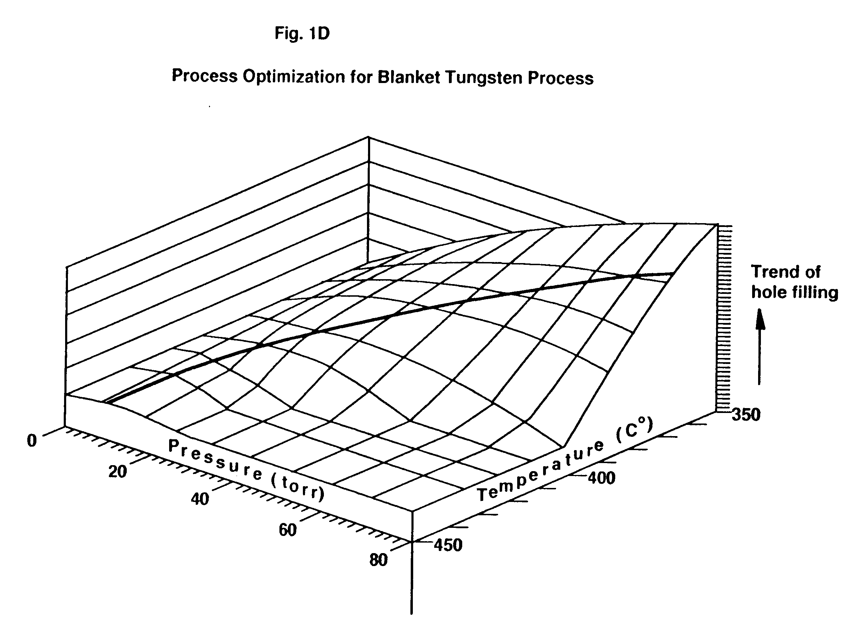

Experience in coating devices with topography having smaller and smaller device geometry and larger and larger aspect ratios has shown that there is a relationship between the pressure of the process gases during CVD processing and the ability to coat evenly into vias and holes, and to do complete hole filling. In general, as pressure increases, step coverage and hole filling improve, pass through a maximum point, and then decrease again. The maximum point has a temperature dependence, and the inventors have seen the maximum vary from 10 to 80 Torr (1 Torr = 133 Pa) total pressure. Fig. 1D is a three-dimensional plot showing how hole filling is effected by pressure and temperature in the apparatus of the present invention. The trend is believed to be similar for CVD equipment in general.

In addition to better step coverage and hole filling at higher pressures, up to a point, higher pressure also typically provides a generally higher deposition rate, increasing throughput and decreasing operating costs per wafer coated. These expected advantages have made higher pressure operation very desirable in processes like blanket tungsten, but the tendency to backside coating caused by higher pressure operation has, up until the present invention, made the high pressure operations difficult and generally impractical. Blanket tungsten, for example, has typically been done at a total process pressure below 1 Torr.

The perimeter wafer seal comprising a proximity seal, as described in the cross-referenced application, has been found with experience to prevent edge and backside coating at total process gas pressures up to about 1 Torr, and acceptable step coverage, defined as 50% or better, is attained at this pressure for wafers exhibiting aspect ratios of up to a maximum of about 3.0 with reduced temperature. A maximum of 1.5 AR is more typical. To operate with high aspect ratios, providing hole filling as necessary, and at significantly higher pressures than 1 Torr, the perimeter wafer seal comprising a proximity seal is not adequate. Under these conditions, the referenced proximity seal allows coating material to migrate and cause undesirable edge and backside coating.

The clearance dimension of the proximity seal in the referenced copending application is determined to allow for expected differences in wafer thickness without losing pressure contact around the perimeter of a captured wafer on the frontside. This dimension is at a practical minimum for those processes with a pressure at or below about 1 Torr. The width of the seal ring forming the proximity seal with the wafer support could be made greater to improve the efficiency of the proximity seal for higher pressures, but the required pressures are so much higher in some cases that extended width is not practical to provide an effective deterrent to edge and backside coating. Processes are being done with total process pressures of 30 Torr and more, and processes are contemplated with total process pressures much higher; perhaps 80 to 100 Torr. An upper limit is not known at this time. What is needed is an apparatus and method to allow these much higher process pressures while using the existing perimeter wafer seal, or a similar seal with relaxed dimensional tolerances.

## Summary of the Invention

In a preferred embodiment of the invention an apparatus is provided for preventing edge and backside coating on wafers in a CVD process, with particular utility for processes with a total process gas pressure above 1 Torr. A wafer seal ring holds a wafer against a CVD chuck contacting the wafer continuously around the periphery of the wafer, forms an annulus around the wafer, and forms a proximity seal around the wafer with a surface of the CVD chuck. An exclusion gas is conducted to the annulus around the wafer, and by flowing out through the proximity seal excludes process gases from migrating into the annulus where coating on the edge and backside of a wafer may occur. The gas is conducted directly to the annulus, rather than behind the wafer, making the proximity seal the main impediment to flow, which limits pressure buildup behind the wafer that would distort the wafer, distorting temperature profile and resulting in thickness non-uniformity of the deposited layer.

In a preferred embodiment, the apparatus includes a carrier attached to the wafer seal ring which supports and moves the ring. In the preferred mode, the carrier for the wafer seal ring includes a guide, a cam track to actuate the carrier, and a spring for applying force to the wafer against the CVD chuck. Also in a preferred embodiment, the surface of the chuck and the surface of the wafer seal ring that form the proximity seal are both flat surfaces, and the gap between them has a depth X and a radial length Y, such that depth X, when combined with the volume rate of flow of exclusion gas, provides an impulse for the exclusion gas equal to or greater than the impulse in the opposite direction of coating gas in the seal area. Radial length Y is equal to or greater than ten times the mean free path of coating gas in the proximity seal.

The invention has an added advantage that the gas introduced around the edge of the wafer provides inert gas in the area between the wafer and the chuck face in a way that heat transfer is effecient and uniform, and the pressure is limited to prevent the wafer from becoming distorted. An additional advantage is that the flow of inert gas through the proximity seal helps to transfer heat from the chuck to the wafer seal ring, so the ring is more nearly the temperature of the wafer, and does not act as a heat sink at the area of contact with the wafer.

## Brief Description of the Drawings

Fig. 1A is a section through a via in a coated wafer to illustrate the meaning of step coverage.

Fig. 1B is a section through a via in a coated wafer to show the closing of a via as aspect ratio becomes larger and coating thickness remains constant.

Fig. 1C is a section through a via in a coated wafer to illustrate the meaning of complete hole filling.

Fig. 1D is a three-dimensional plot of tendency to fill holes in a CVD process, related to temperature and pressure.

Fig. 2 is an elevation view of a CVD chuck and a wafer seal ring apparatus in the preferred embodiment.

Fig. 3 is a face-on view of a CVD chuck in the apparatus of the preferred embodiment.

Fig. 4 is a side view of the CVD chuck of Fig. 3 with a section to show the arrangement of gas passages in the chuck.

Fig. 5 is a section view showing the chuck, the wafer seal ring, and a wafer in the arrangement of the preferred embodiment, to show how inert gas is provided to the wafer to exclude coating gas at the edge and backside of the wafer.

Fig. 6 is a section similar to the section of Fig. 5, but showing an early experiment that was not successful.

Fig. 7 is a plot of temperature profiles on wafers under varying flow conditions at a process pressure of 6.5 Torr, for the experiment illustrated by Fig. 6.

Fig. 8 is a plot of temperature profiles on wafers under varying flow conditions at a process pressure of 30 Torr, for the experiment illustrated by Fig. 6.

Fig. 9 is a plot of temperature profiles for wafers under various flow conditions in the appareatus of the preferred embodiment.

Fig. 10 is a table of uniformity measurements on wafers processed in the apparatus of the preferred embodiment.

## Description of the Preferred Embodiments

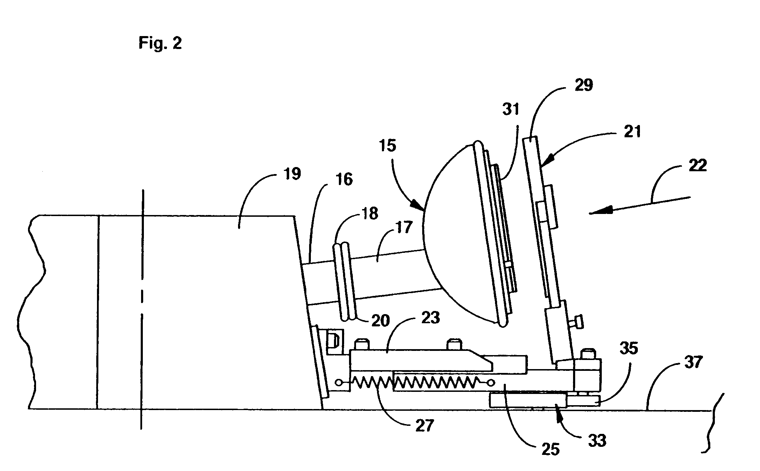

Fig. 2 is a side view of a single station of a chuck assembly with a perimeter wafer seal comprising a proximity seal according to the invention of the the cross-referenced copending application, with addition of passages and associated equipment to flow non-reactive gas from outside the reaction chamber to inlets on the wafer side of the perimeter wafer seal. The gas passages and associated equipment are not shown in Fig. 2. In this specification the inert gas flowed to the wafer side of the perimeter wafer seal is referred to as exclusion gas, because the purpose is to exclude migration of process gas that could cause coating on the edge or backside of a wafer. Also in this specification, by perimeter proximity seal the inventors mean a gap intentionally maintained between the seal ring and the CVD chuck.

A CVD chuck assembly 15 for supporting and heating a wafer to be processed is mounted on a mounting arm 17 that extends from a central hub 19. An extension 16 from the central hub has a flange 18, and arm 17 has a mating flange 20 in the preferred embodiment for mounting chuck assembly 15 to the central hub. In the preferred mode there are six CVD chuck assemblies mounted at different angular positions from the central hub, and the hub is rotatable. There can be more or fewer than six chucks assemblies.

A perimeter wafer seal apparatus 21 associated with the CVD chuck includes a mounting apparatus 23 extended from the central hub, a slide arm 25 urged toward the central hub by a spring 27 and a seal ring 29 that moves with the slide for holding a wafer 31 against the CVD chuck and for forming a proximity seal with a surface of the chuck. A cam track apparatus 33 fastened to the floor 37 of the CVD chamber in the preferred embodiment engages a cam follower 35 attached to slide arm 25 to move seal ring 29 away from the CVD chuck at one position in the rotation of the central hub so wafers can be unloaded from and loaded to the chuck. The wafer seal apparatus is shown away from the wafer in Fig. 2, as would be the case at the load/unload position. At rotary positions away from the load/unload position the cam follower is not engaged and spring 27 causes ring 29 to urge against wafer 31.

The central hub, the CVD chucks, the seal rings, and associated apparatus are all enclosed in a sealable CVD chamber (not shown). There is a sealable opening at the load/unload position where a wafer may be passed out of or into the chamber from a load-lock or other volume outside the CVD chamber.

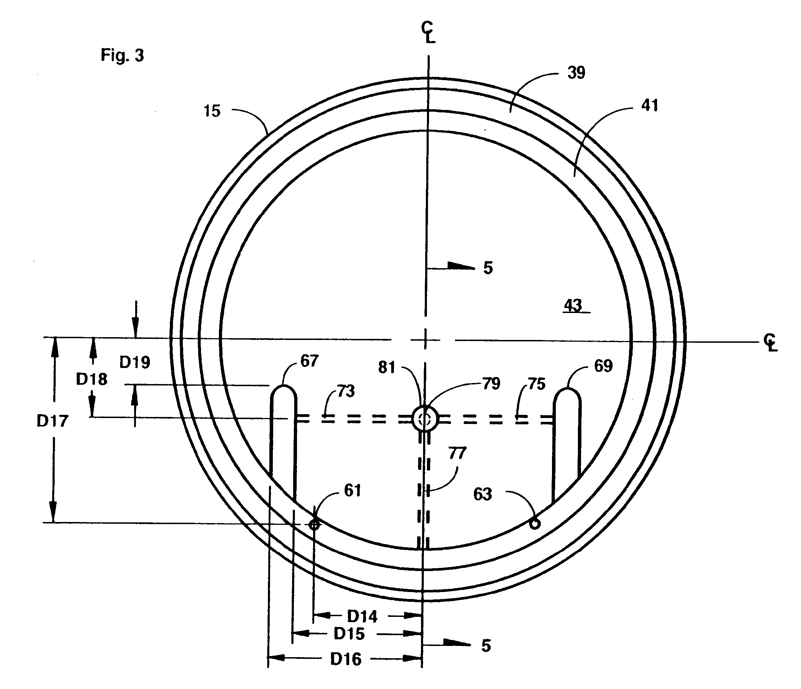

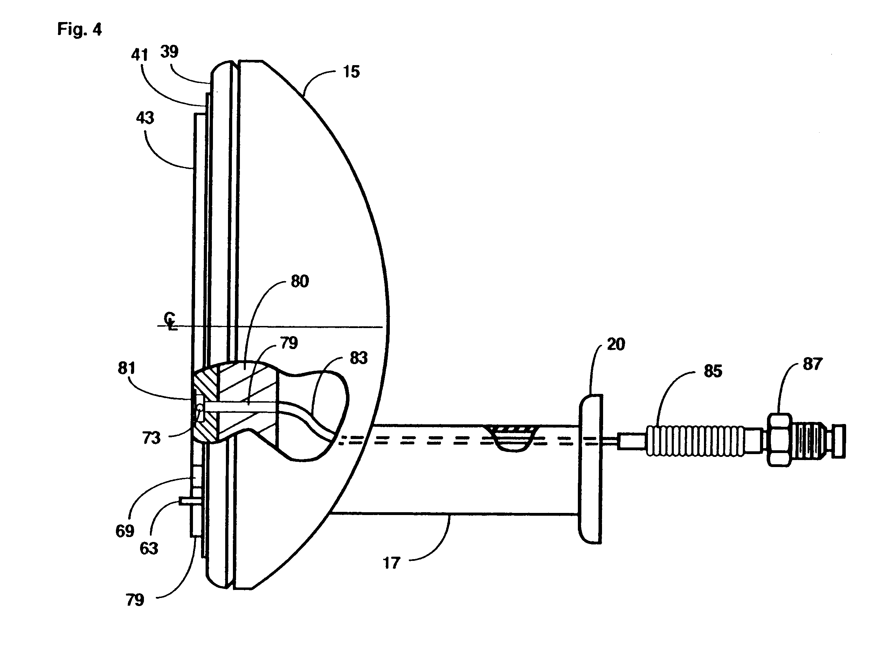

Fig. 3 is a face-on view of the face of CVD chuck assembly 15 in the direction of arrow 22, without wafer 31 or wafer seal apparatus 21. Fig. 4 is a side view of the chuck assembly of Fig. 3, disconnected from the central turret at flange 20., A wafer, when loaded on the chuck assembly, rests on pins 61 and 63, which protrude from surface 41 of the chuck assembly and extend beyond surface 43, such that a loaded wafer rests against surface 43. In another embodiment the pins project from surface 43, and surface 43 is somewhat larger in diameter than the wafer to be processed. Slots 67 and 69 in surface 43 are clearance slots for appendages of a loading arm (not shown) that loads and unloads wafers to and from the chuck assembly in the preferred embodiment. The clearance slots extend in depth to surface 41, which is a machined surface forming one side of a proximity seal with seal ring 29. In a preferred embodiment for a 150 mm nominal diameter wafer D14 is about 51.3 mm, D15 is about 57.3 mm, D16 is about 66.7 mm, D17 is about 56.2 mm, D18 is about 24 mm, and D19 is about 16.8 mm.

A non-reactive exclusion gas, argon in the preferred embodiment, is conducted via lateral passages 71, 75 and 77, which are bored into the monel material of the chuck face. Two of the lateral passages terminate in slots 67 and 69, and the third through wall 79 between surfaces 43 and 41. The three lateral passages are each about 2.6 mm in diameter. Lateral passages 73, 75 and 77 lead from a central passage 79 that extends through the chuck base and a copper heating block 80, and is plugged at surface 43 by a welded plug 81.

Gas is conducted to passage 79 through stainless steel tubing 83 in the preferred embodiment, and the tubing is connected to a bellows 85 for alignment. The bellows is connected to a tube fitting 87 that connects in assembly to a mating fitting (not shown) from the central hub. Gas is fed to the several stations from a pressurized reservoir through a flow control device (not shown).

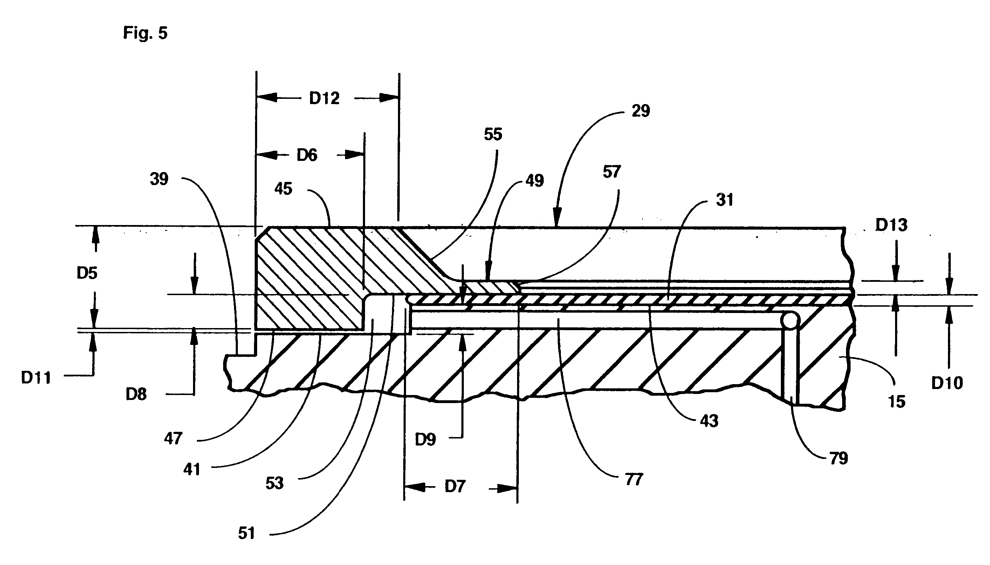

Fig. 5 is a partial section view showing wafer 31 held against CVD chuck assembly 15 by seal ring 29. The section is taken along section line 5-5 of Fig. 3. In Fig. 5 the wafer seal apparatus is closed, and the seal ring is urged against a wafer on the chuck with a force of about 10 pounds in the preferred embodiment.

The front of CVD chuck 15 has three levels in the preferred embodiment: a base level 39, first raised surface 41, and face 43. The first raised surface is circular and has an outer diameter substantially the same as the outer diameter of wafer seal ring 29. Surface 43 in the preferred embodiment is substantially the size of the backside of a wafer to be processed, and differs in size for chucks made to accomodate different wafers. In other embodiments surface 43 is somewhat larger in diameter than the wafer. When a wafer is loaded to the CVD chuck, the wafer rests against surface 43. Although surface 43 in the preferred embodiment has about the same diameter as the wafer to be loaded, it has no complementary shape to wafer flats that are formed on the edge of wafers for orientation and identification purposes. In the preferred mode, surfaces 41 and 43 are carefully machined and polished to be flat within about .025 mm over the expanse of each surface.

Wafer seal ring 29 has an outer portion 45 with a thickness D5 in the preferred embodiment of about 12 mm. and a flat machined surface 47 orthogonal to the axis of the seal ring. Width D6 of surface 47 in the diametral direction is a minimum of about 10.5 mm in the preferred embodiment. The outside diameter of ring 29 and of chuck assembly 15 in the preferred embodiment is about 25 cm, and the diameter of surface 43 is provided in the manufacture of chucks to accomodate specific standard wafer sizes from 200 mm and smaller. The common larger outer diameter allows many common parts to be used in systems assembled to coat wafers of different standard sizes.

The seal ring has an inner portion 49 with a flat machined surface 51 parallel to surface 47. Surface 51 is the surface that contacts the frontside of a wafer when the seal apparatus closes. Surface 51 extends toward the ring center to an extent that an overlap D7 of between 3 and 5 mm is created, and the inner periphery is machined as a series of flats (not shown) so that a wafer with any standard flat of the nominal diameter for which a chuck and seal ring have been prepared, may be loaded and contacted by the seal ring continuously around the outer periphery of the wafer. It is important that contact with the wafer be continuous. The provision of flats and wafer orientation are not critical to the invention.

The spacing D8 between surfaces 47 and 51 is controlled in machining relative to distance D9 and the thickness D10 of wafer 29 to control gap dimension D11 between surface 41 of the CVD chuck and surface 47 of the wafer seal ring. For example, for a nominal 100 mm diameter wafer with the apparatus of the preferred embodiment, D8 is 4.37 mm (172 inches) plus or minus .0127 mm (.0005 inches), wafer thickness D10 is known to vary from .602 mm (.0237 inch) to .648 mm (.0255 inch), and D9 is 3.81 mm (.150 inches) plus or minus .0127 mm (.0005 inches). The maximum gap D11 is the maximum wafer thickness .648 mm (.0255 inches), plus the maximum D9 dimension of .3823 mm (.1505 inches), less the minimum D8 dimension of 4.356 mm (.1715 inches), or D11 = .114 mm (.0045 inches). The minimum gap D11 is the minimum wafer thickness .602 mm (.0237 inches), plus the minimum D9 dimension of 3.797 mm (.1495 inches), less the maximum D8 dimension of 4.382 mm (.1725 inches), or D11 = .0178 mm (.0007 inches). In measurements of a system in use with tolerances equal to those described above for a 100 mm nominal wafer, the gap width D11 was found to vary from .031 mm (.0012 inches) to .102 mm (.004 inches); a very good correlation in practice to theoretical tolerances. The width D6 of surface 47 together with gap D11 between surface 47 and surface 51 forms a perimeter proximity seal around the wafer on the chuck, which, together with the continuous contact between surface 51 and the frontside of the wafer around the perimeter of the wafer, forms a barrier to the migration of coating gases in process to the edge or the backside of a wafer held in the perimeter wafer seal.

The outer diameter of surface 51 of the seal ring has to be greater than the outer diameter of a wafer to be processed and also greater than the diameter of raised surface 43, and an annulus 53 is enclosed at the edge of the wafer inside the seal ring. The width of this annulus provides clearance for operation, and must also be greater than the diameter of pins 61 and 63 that support a wafer when the wafer seal apparatus is open. The width of annulus 53 in the preferred embodiment is about 6 mm. The width could be greater or smaller, as long as the annulus does not become a greater impedance to gas flow than the proximity seal.

Outer portion 45 of seal ring 29 is joined to inner portion 49 by an angled surface 55. In the preferred embodiment dimension D12 for a wafer of 200 mm diameter is about 15 mm and the angle of surface 55 with the axis of the ring is about 45 degrees. It has been found that an angle is an advantage in many CVD processes to avoid interference with flow of gases to the frontside of the wafer, which might cause an uneven distribution of deposited material. The angle, however, can be as small as 20 degrees, and may begin almost at the inner periphery of the seal ring. The thickness D13 of the inner portion of the seal ring in the preferred embodiment is about 1.02 mm (.040 inches), with a chamfer 57 of about .51 mm (.020 inches) by 45 degrees. The relatively thin section and the chamfer both help to avoid disturbance in the flow of CVD gases to the frontside of the wafer during processing, especially near the area of contact with the frontside of the wafer. The more massive outer portion of the ring provides stability during temperature excursions that might otherwise warp or fracture the ring. The ring material, like the chuck material, is monel metal in the preferred embodiment.

Section view Fig. 5 additionally shows gas passage 77 leading from passage 79 into annulus 53. Inert gas is flowed into annulus 53 for relatively high pressure processes, generally above 1 Torr total pressure, as an aid in excluding coating gas flow or diffusion through the gap between surfaces 41 and 47, the proximity seal. In preparing to process wafers in a low pressure process, generally below 1 Torr total pressure, the volume of the CVD chamber is evacuated, establishing a vacuum. The vacuum level between deposition cycles is typically about 1 millitorr. To initiate deposition, CVD gases are introduced into the chamber. When gas is first conducted into the CVD chamber there is a pressure differential between volume 53 around the edge of a wafer clamped on a chuck by a wafer seal ring and the rest of the CVD chamber. This pressure differential will cause gas to flow through gap D11 of the perimeter proximity seal into annulus volume 53. The flow will decrease over time, because the pressure will rise in volume 53 decreasing the pressure difference toward equalibrium. To avoid introduction of gas to volume 53 that would cause deposition on the wafer edge, the first gas typically introduced before deposition begins is an inert gas, such as argon; a gas that will not cause deposition. The gas bearing the material to be deposited, such as tungsten hexafluoride for a deposition of tungsten or an alloy of tungsten, is introduced only after enough time has passed for pressure equalibrium to be established between the chamber and the small volume 53 around the edge of wafers on the chucks.

Because pressure equalibrium is established between the small volume around a wafer inside the seal ring and the rest of the CVD chamber by the introduction of an inert gas, the only mechanism by which material might enter volume 53 and cause deposition on the edge or the backside of a wafer is by diffusion. The material in CVD processing is introduced as a gas, such as tungsten hexafluoride for tungsten. The CVD chuck and the ring are at a high temperature, such as 400 to 600 degrees Centigrade. The CVD gas bearing the material to be coated will tend to migrate in the D11 gap of the perimeter proximity seal due to molecular diffusion action at the high temperature, but will also tend to coat on chuck surface 41 and ring surface 47 in the gap. If gap dimension D11 is relatively small, and gap width D6 is relatively large, there will be a high probability of collisions of gas molecules with surfaces 41 and 47 and a high probability of depletion of the coating material in the gap before reaching volume 53, where coating might be precipitated on the edge or the backside of a wafer.

It has been found in trial depositions that with a dimension D6 of 10.67 mm (.420 inches) for the perimeter proximity seal, and with total process pressures up to about 1 Torr, that gap D11 can vary from 0 to about .279 mm (.011 inches), before any signs of edge coating appear. This is a ratio of width to length of about 38:1. Generally it has been found that to be effective for processes with a total pressure of about 1 Torr and below, and without exclusion gas flow, the perimeter proximity seal should have a width to gap ratio of more than 35:1, preferrably more than 38:1, and most preferred, a ratio of about 80:1 or higher.

In practice, a gap of 0 is not attainable, because of the realities of machining tolerances, and the fact that interference (touching) of surfaces 41 and 47 means that pressure is relieved on the face of the wafer, and surface 51 will not everywhere contact the wafer. Dimensions are controlled so the D11 gap of the perimeter proximity seal is not less than about .025 mm (.001 inch). It is preferable to operate with a larger gap respecting the 35:1 ratio of width to gap dimension, because as material deposits in the gap, the gap becomes smaller, until it is necessary to pause for a cleaning operation to restore the original dimensions and tolerances.

For process requiring a total pressure of process gases below 1 Torr, the perimeter wafer seal with a proximity seal as described above is adequate to prevent edge and backside coating on wafers. For processes requiring total pressure of the process gases above about 1 Torr, the proximity seal alone is not always adequate to prevent edge and backside,coating on a wafer. For the processes with a total pressure above 1 Torr an inert gas is flowed to annulus 53 via passages 73, 75 and 77.

When no exclusion gas is used, the gap to width ratio is quite important, as was described and claimed in the cross-referend copending application. When gas is flowed from behind the seal ring to exclude coating gases, the situation is somewhat different. In that case it is important that the impulse (mass times velocity) of the exclusion gas radially outward in gap D11 be equal to or greater than the impulse of coating gas diffusing in the opposite direction.

The coating gas is typically not the only gas in the mixture admitted to a CVD chamber for coating. There is also a carrier gas, such as argon or hydrogen. The diffusion speed of the coating gas will vary depending on a number of variables, such as the total gas pressure, the kind of carrier gas used, and the temperature. Regardless of the carrier gas, however, to diffuse against a flow of exclusion gas, the coating gas must diffuse in the exclusion gas.

A diffusion constant is a measure of the expected rate of diffusion in all directions from a source point of one gas in another gas, and is typically expressed in units of square centimeters per second. Diffusion constants under various conditions are known in the art and published, and there are formulas known in the art for calculating diffusion constants. Diffusion constants can also be measured by various techniques, such as introducing gas at one place in a system and measuring change in concentration at another,such as by gas chromatography or mass spectrometry. There are also formulas known in the art for calculating the diffusion speed once a good value for the diffusion constant is known. One such formula is:

$$v = \text{square root}(2Dt) / t$$

where v is the average diffusion speed, D is the diffusion constant, and t is time.

The diffusion constant for tungsten hexafluoride at 400 degrees centigrade in argon at a total gas pressure of 1 Torr is about 50 square cm per second. Rate of diffusion is inversely proportional to total pressure, so for a 30 Torr pressure at 400 degrees centigrade the tungsten hexafluoride constant for argon is about 1.67 square cm per second. The diffusion speed for tungsten hexafluoride in argon is then about 1.8 cm per second.

The speed for exclusion gas can be calculated from the formula:

$$Q = (n) (v) (A)$$

where Q is flow, n is concentration and A is the cross section of the flow path. For example, if the flow of exclusion gas for one seal ring is 50 sccm, the radius of the seal ring is about 100 mm, and the gap D11 is about .1 mm (.004 inches), the exclusion gas velocity can be calculated to be about 34 cm per second.

The mass number for tungsten hexafluoride is 300, and for argon exclusion gas is 40. So, given the previously calculated velocities, the impulse for tungsten hexafluoride in this example is 540, and for the exclusion gas 1360. The impulse for the exclusion gas is about 2.5 times the impulse for tungsten hexafluoride, providing a reasonable expectation of excluding coating gas from behind the seal ring.

The width of the gap should be about ten times the mean free path or more of tungsten hexafluoride at the given temperature and pressure. Methods for calculating mean free path under various conditions are known in the art, and for tungsten hexafluoride the mean free path at 30 Torr and 400 degrees centigrade is about 4 micrometers. Ten times four micrometers is 40 micrometers, or .04 mm (.001 inch). In the preferred embodiment the gap length is about 2 cm, enough to be more than ten times the mean free path for the entire range of total pressure from 1 Torr to atmospheric pressure.

In earlier efforts by the inventors to prevent backside deposition by introducing an inert gas, gas was introduced through passages terminating directly behind the wafer. Many experiments have been conducted with inert gas flow, both with and without seal rings, and with gas introduced behind a wafer in various ways, but results were only marginally successful. For example, gas fed during process directly behind a wafer has been partially successful in preventing coating on the backside of a wafer, but does not prevent edge deposition. A wafer, in this arrangement, is also difficult to support on a chuck, as the gas flow tends to move the wafer away from the chuck surface. Moreover, the wafer movement causes serious problems in temperature uniformity, and hence in thickness uniformity, because temperature effects deposition rate.

Holding a wafer against a chuck at plural points around the wafer perimeter has also been tried with inert gas flow behind a wafer, but the uneven aspect of the force against the wafer again contributes to uneveness in temperature and results in lack of uniformity in thickness.

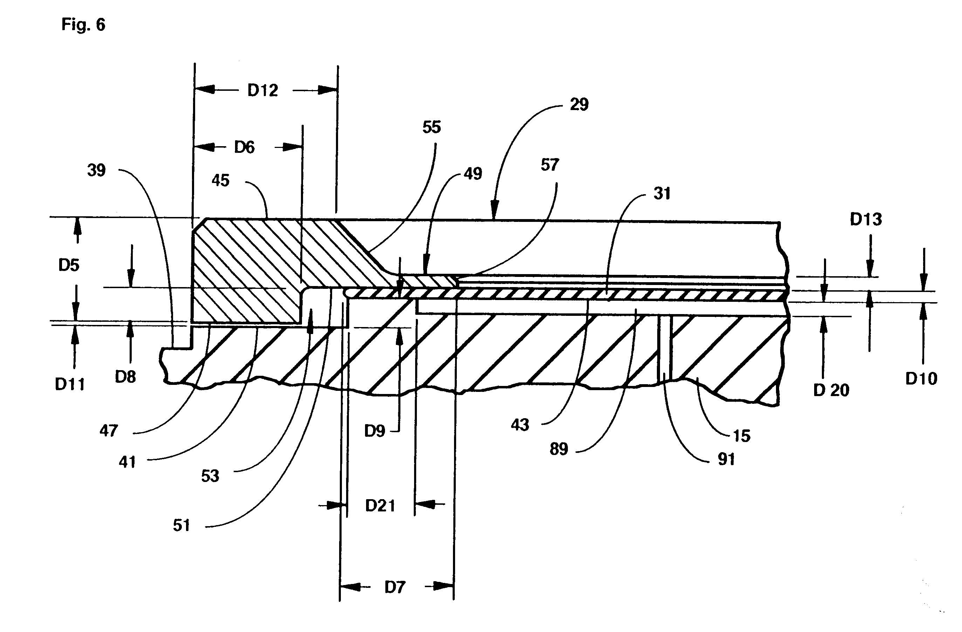

To better illustrate the sensitivity of a wafer to flow of gas to the backside of the wafer, results of earlier experiments are included here. Fig. 6 shows the cross section of Fig. 5, except in Fig. 6 a cavity 89 is machined behind the wafer and gas is conducted to the cavity through a passage 91. The depth D20 of cavity 89 is about 1.5 mm. The seal ring with proximity seal is as described above, and diametral distance D21 is about 7 mm, although the results have been shown to be relatively insensitive to D21.

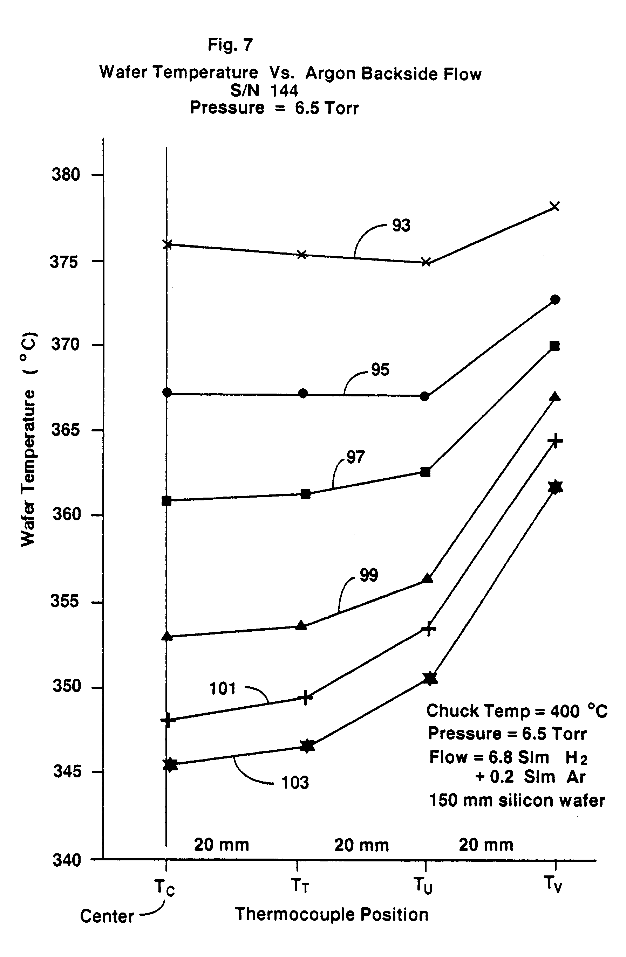

Fig. 7 is a plot of wafer temperature measured by thermocouples at the center of a wafer and at intervals of 20 mm radially for a blanket tungsten process at a total pressure of 6.5 Torr using the apparatus according to Fig. 6. The argon flow rate to prevent edge and backside coating was determined emperically to be 300 sccm with this design. Plot 93 is without gas flow. The total deviation in temperature is over a range of about three degrees C. Other experimental measurements have shown that each degree in temperature deviation results in a thickness deviation of about 1%. Thus, the thickness deviation is acceptable with the above arrangement, but the absence of gas flow promotes undesirable edge and backside coating.

Plot 95 is for 25 sccm argon, plot 97 for 50 sccm, plot 99 for 100 sccm, plot 101 for 150 sccm, and plot 103 for 200 sccm for the arrangement of Fig. 6. The temperature deviation, and hence the thickness deviation is seen to get steadily worse as flow is increased, such that at plot 103, with 200 sccm argon flow, the thickness deviation may be expected to be 15%, an amount that is completely unacceptable. Yet the required 300 sccm of argon to prevent edge and backside coating has not been reached.

Visual inspection during processing shows that the wafer, although held firmly at the perimeter, bows outward to the center. It is believed that the bowing produces non-uniformity in heat transfer resulting in the non-uniformity in temperature profile and thickness profile.

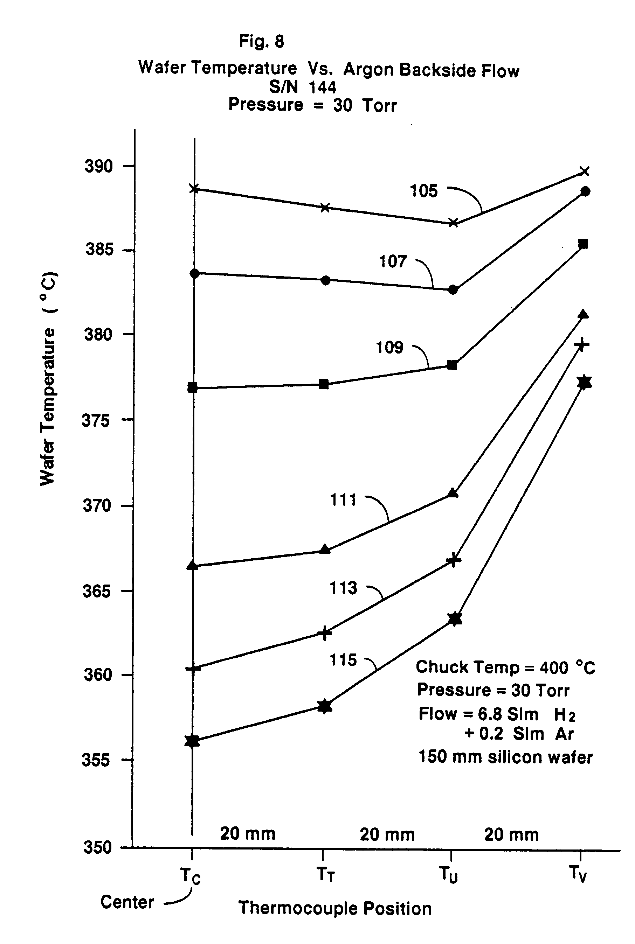

Fig. 8 shows the same situation as Fig. 7, except the total process pressure is 30 Torr. Plot 105, 107, 109, 111, 113 and 115 are for argon flow of 0, 25, 50, 100, 150 and 200 sccm, as before. Again, the deviation is nominal with no flow and deteriorates as flow increases, until, at 200 sccm, the deviation is more than 20 degrees C.

When gas is introduced behind a wafer and the wafer is held to the chuck around the perimeter, with or without a cavity such as cavity 89 in Fig. 6, the proximity seal does not appear to be the limiting impediment to gas flow. Instead, it appears that the contact of the wafer to the chuck is the limiting influence, and that a greater pressure of gas is needed to force a flow than is needed to force the same flow through only the proximity seal, hence the bowing of the wafer.

With peripheral introduction of exclusion gas into annulus 51, as shown in Fig. 5, the proximity seal is the limiting impedance for gas flow. Still, at 300 sccm, the pressure in annulus 51 has been determined to be about 40 Torr for a total process pressure of 30 Torr, a difference of about 10 Torr. It is known that at a microscopic level the actual contact of the wafer with the chuck surface, even with the surface held to a flatness of .025 mm across the surface, is a contact of a large number of points, and gas may flow between the wafer surface and the chuck surface. Gas at 40 Torr from annulus 51 flows behind the wafer and establishes an equilibrium at about 40 Torr, the same pressure as in annulus 51. This is a much lower pressure than that behind the wafer with gas introduced as in Fig. 6, and does not cause bowing. Consequently, heat transfer is by conduction through the gas behind the wafer and is very uniform. Uniformity is enhanced at the higher pressures because intermolecular distance (mean free path) is smaller at higher pressure, and conduction becomes the primary mechanism for heat transfer from the chuck surface to the wafer.

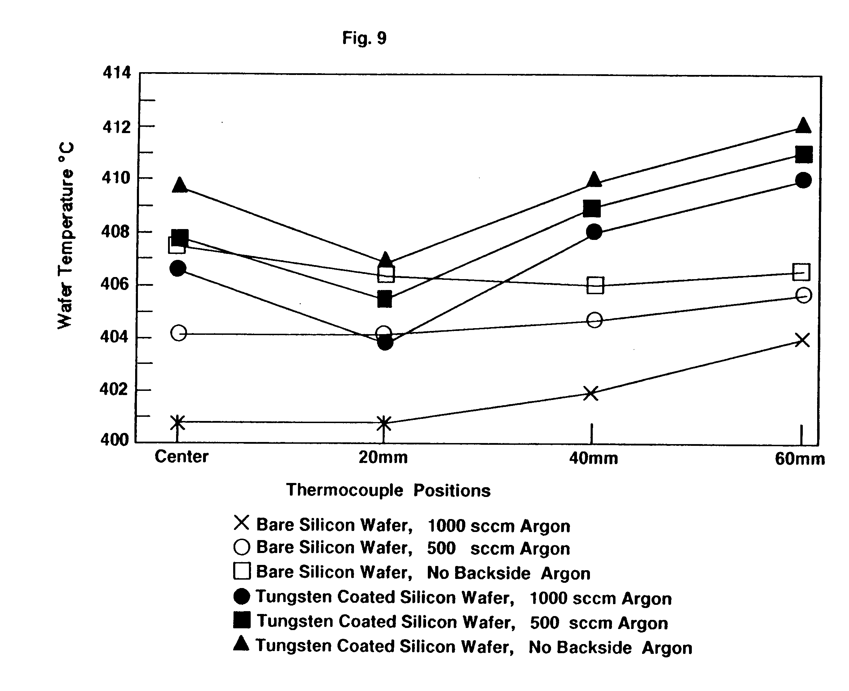

Fig. 9 is a temperature profile of several experiments performed with the apparatus of the preferred embodiment as described above. Argon gas flow to annulus 51 was changed from 1000 sccm to 500 sccm and to 0 sccm for a bare silicon wafer, and in the same increments for a tungsten coated silicon wafer. For the bare wafer, the temperature deviation was about 3 degrees, and was essentially the same for all three gas flows. For the tungsten coated wafer, the temperature deviation was about 5 degrees, and again did not change for the three flow levels. This result shows that temperature deviation is essentially independent of gas flow to the seal annulus in the preferred embodiment, although there is some dependence on coating material, likely due to a difference in emmisivity.

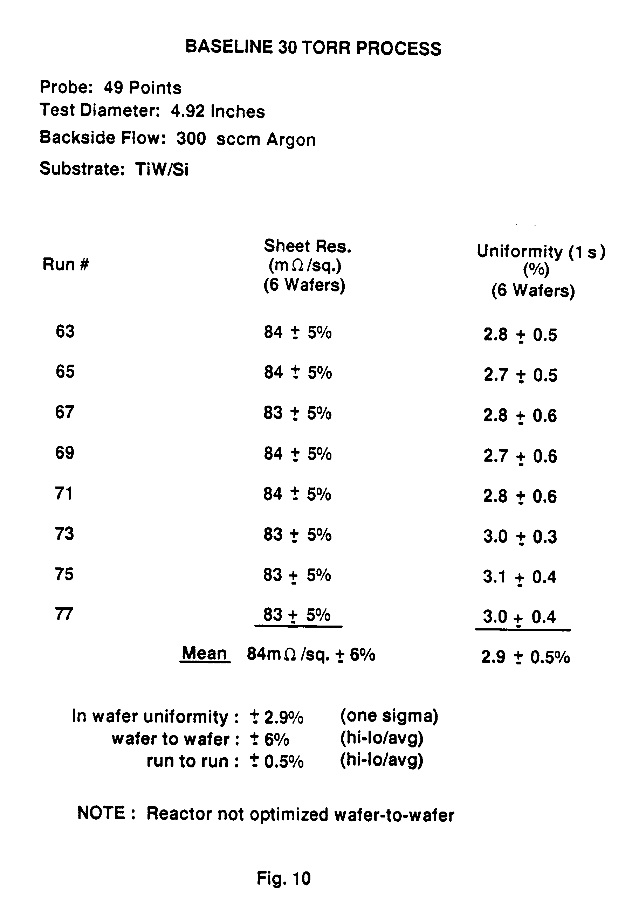

Fig. 10 is a table of uniformity measurements made of wafers deposited in a Ti/Tungsten process at a total process pressure of 30 Torr with the apparatus of the preferred embodiment and a gas flow of 300 sccm to the seal annulus. The uniformity on any wafer is seen to be within 2.9 % (1 sigma), wafer-to-wafer within 6%, and run-to-run within .5%.

There is an added benefit from the gas flow with the proximity seal relative to coating uniformity. Typically the seal ring is heated by proximity to the CVD chuck, and the small dimension of the proximity seal facilitates that heating effect. Ideally, the ring should be at the same temperature as the CVD chuck and the wafer. Due to the relatively large surface area of the ring, however, and the fact that it does not contact the chuck directly, the ring can act as a heat sink where it contacts the wafer, and draw heat from the wafer, creating a circular area of low temperature on the wafer near the ring. This temperature variation can cause deposition rate variation and effect the uniformity and quality of coating across the wafer. The typical way of dealing with this effect is to allow a sufficient time for temperature equalibrium to be established. It has been recorded in practice that the flow of inert gas, resulting in a locally high gas pressure in the proximity seal area, provides a more effecient transfer of heat from the CVD chuck to the seal ring than without the gas flow, improving the uniformity variation due to the heat sink effect.

One of ordinary skill in the art will be aware that there are many variations that may be made in the preferred embodiments described. For example, there are a number of different kinds of gases that could be used as the exclusion gas. Argon is used in the preferred embodiment, but Nitrogen or some other inert gases might be suitable. Similarly, there are many ways that a CVD chamber might be constructed and still be equipped to hold a wafer with a perimeter wafer seal, a proximity seal, and exclusion gas flow as in the invention. The gas must be conducted to the annulus area around the wafer held in a perimeter wafer seal ring, but the number and position of passages entering may vary widely. The invention is also not limited to a particular wafer size. Equipment according to the invention can be built to process wafers of any size that are practical for integrated circuit manufacture.

The proximity seal used with processes for which the total process pressure is below 1 Torr and without exclusion gas requires a width to length ratio of 35 to 1 or greater, but with an exclusion gas, the gap can be wider and the width narrower, and still be operable, as long as sufficient exclusion gas is flowed so the impulse for the exclusion gas is larger than the impulse for the coating gas to be excluded.

## Claims

1. An apparatus for preventing edge and backside coating on a wafer during a CVD process comprising:

   CVD chuck means for supporting a wafer during a deposition process;

   wafer seal ring means for holding said wafer against said CVD chuck means, said wafer seal ring means contacting said wafer around the periphery of said wafer on the side of said wafer away from said CVD chuck means, forming an annulus volume around said wafer, and forming a perimeter proximity seal with a surface of said CVD chuck means outside the perimeter of said wafer; and

   gas delivery means for delivering exclusion gas to said annulus volume.

2. Apparatus as in claim 1 further comprising carrier means attached to said wafer seal ring for supporting and moving said wafer seal ring.

3. Apparatus as in claim 2 further comprising:

   guide means attached to said carrier means for guiding said carrier means toward and away from said CVD chuck means;

   actuator means for advancing said carrier means toward said CVD chuck means and retracting said carrier means from said CVD chuck means; and

   pressure means associated with said carrier means for pressing said wafer seal ring against said wafer on said CVD chuck means.

4. Apparatus as in claim 1 wherein said perimeter proximity seal comprises a first surface on said seal ring and a second surface on said CVD chuck means, said first surface substantially conforming in shape to said second surface and separated from said second surface by a distance X over a radial length Y such that distance X combined with the volume flow of said exclusion gas in said proximity seal provides an impulse for said exclusion gas greater than the impulse for a coating gas in the opposite direction during processing, and said radial length Y is equal to or greater than ten times the mean free path of coating gas in said proximity seal.

5. An apparatus as in claim 4 wherein said first surface and said second surface are both flat surfaces.

6. Apparatus as in claim 1 wherein said CVD chuck means comprises a passage into said annulus volume, and wherein said gas delivery means conducts said exclusion gas through said passage.

7. A method of preventing CVD deposition on the edge and the backside of a wafer during CVD processing comprising the steps of:
   placing a seal ring over said wafer;
   urging said seal ring against said wafer to press the backside of said wafer against a CVD chuck, said seal ring contacting the frontside of said wafer around the periphery of said wafer, forming a perimeter proximity seal with said CVD chuck, and forming an annulus volume between said seal ring and said wafer; and
   flowing exclusion gas directly into said annulus volume.

8. A system for performing a CVD process on a wafer comprising:
   A CVD chamber;
   CVD chuck means within said CVD chamber for holding said wafer during processing;
   heating means to heat said wafer during processing;
   process gas flow means for flowing process gases into said chamber during processing;
   perimeter wafer seal means for creating a seal around said wafer and between said wafer and said CVD chuck means; and
   gas delivery means for supplying an exclusion gas through said CVD chuck means;
   said perimeter wafer seal means comprising:
      a wafer seal ring for holding said wafer against said CVD chuck means; and
      said wafer seal ring contacting said wafer continuously around the periphery of said wafer on the side of said wafer away from said CVD chuck means, forming an annulus volume around said wafer, and forming a perimeter proximity seal with said CVD chuck means outside the perimeter of said wafer, said gas delivery means supplying exclusion gas to said annulus volume.

9. A system as in claim 8 further comprising a rotatable hub within said CVD chamber, said CVD chuck means attached to said rotatable hub.

10. A system as in claim 8 further comprising:
    carrier means attached to said wafer seal ring for supporting and moving said wafer seal ring;
    guide means attached to said carrier means for guiding said carrier means toward and away from said CVD chuck means;
    actuator means for advancing said carrier means toward said CVD chuck means and retracting said carrier means from said CVD chuck means; and
    pressure means associated with said carrier means for pressing said wafer seal ring against said wafer on said CVD chuck means.

11. A system as in claim 8 wherein said perimeter proximity seal comprises a first surface on said seal ring and a second surface on said CVD chuck means, said first surface substantially conforming in shape to said second surface and separated from said second surface by a distance X over a radial length Y such that distance X combined with the volume flow of said exclusion gas in said proximity seal provides an impulse for said exclusion gas greater than the impulse for a coating gas in the opposite direction during processing, and said radial length Y is equal to or greater than ten times the mean free path of coating gas in said proximity seal.

12. A system as in claim 11 wherein said first surface and said second surface are both flat surfaces.

**Patentansprüche**

1. Vorrichtung zum Verhindern des Beschichtens von Kanten und Rückseiten bei einem Wafer während eines CVD-Prozesses, mit:
   einer CVD-Einspanneinrichtung zum Halten eines Wafers während eines Ablagerungsprozesses;
   einer Wafer-Dichtringeinrichtung zum Halten des Wafers gegen die CVD-Einspanneinrichtung, wobei die Wafer-Dichtringeinrichtung den Wafer um den Außenumfang des Wafers auf der Seite des Wafers, die weg von der CVD-Einspanneinrichtung liegt, berührt, wobei ein Ringvolumen um den Wafer gebildet wird und wobei eine Dichtung nahe der Umfangsbegrenzungslinie mit einer Fläche der CVD-Einspanneinrichtung außerhalb der Umfangsbegrenzungslinie des Wafers gebildet wird; und
   einer Gaszufuhreinrichtung zum Zuführen von Inhibitionsgas zu dem Ringvolumen.

2. Vorrichtung nach Anspruch 1, die weiterhin eine Trägereinrichtung aufweist, welche an dem Wafer-Dichtring befestigt ist, um den Wafer-Dichtring zu tragen und zu bewegen.

3. Vorrichtung nach Anspruch 2, die weiterhin aufweist:

eine Führungseinrichtung, die an der Trägereinrichtung befestigt ist, um die Trägereinrichtung auf die CVD-Einspanneinrichtung zu und von ihr weg zu führen;

eine Antriebseinrichtung zum Vortreiben der Trägervorrichtung in Richtung auf die CVD-Einspanneinrichtung und zum Zurückziehen der Trägereinrichtung von der CVD-Einspanneinrichtung; und

eine Druckeinrichtung, die der Trägereinrichtung zugeordnet ist, um den Wafer-Dichtring gegen den Wafer auf der CVD-Einspanneinrichtung zu drücken.

4. Vorrichtung nach Anspruch 1, bei der die Dichtung nahe der Umfangsbegrenzungslinie eine erste Fläche auf dem Dichtring und eine zweite Fläche auf der CVD-Einspannvorrichtung aufweist, wobei die erste Fläche in ihrer Form im wesentlichen der zweiten Fläche angepaßt ist und von der zweiten Fläche um einen Abstand X über eine radiale Länge Y getrennt ist, so daß der Abstand X multipliziert mit dem Volumenstrom des Inhibitionsgases in der nahe liegenden Dichtung einen Impuls für das Inhibitionsgas liefert, der größer ist als der Impuls für ein Beschichtungsgas in der entgegengesetzten Richtung während der Bearbeitung, und die radiale Länge Y gleich oder größer ist als das Zehnfache der mittleren freien Weglänge des Beschichtungsgases in der nahe angeordneten Dichtung.

5. Vorrichtung nach Anspruch 4, bei der die erste Fläche und die zweite Fläche beide ebene Flächen sind.

6. Vorrichtung nach Anspruch 1, bei der die CVD-Einspanneinrichtung einen Durchlaß in das Ringvolumen aufweist und bei der die Gaszufuhreinrichtung das Inhibitionsgas durch den Durchlaß leitet.

7. Verfahren zum Verhindern der CVD-Ablagerung auf den Kanten und auf der Rückseite eines Wafers während der CVD-Bearbeitung, mit den Schritten:

Auflegen eines Dichtringes über den Wafer;

Zwingen des Dichtringes gegen den Wafer, um die Rückseite des Wafers gegen ein CVD-Spannfutter zu drücken, wobei der Dichtring die Vorderseite des Wafers um den Außenumfang des Wafers herum berührt, wobei eine Dichtung nahe der Umfangsbegrenzungslinie mit dem CVD-Spannfutter gebildet wird und ein Ringvolumen zwischen dem Dichtring und dem Wafer gebildet wird; und

Einströmen von Inhibitionsgas direkt in das Ringvolumen.

8. System zum Durchführen eines CVD-Prozesses auf einem Wafer, mit:

einer CVD-Kammer;

einer CVD-Einspanneinrichtung innerhalb der CVD-Kammer zum Halten des Wafers während der Bearbeitung;

einer Heizeinrichtung zum Erhitzen des Wafers während der Bearbeitung;

einer Prozeßgas-Strömungseinrichtung zum Einströmen von Prozeßgas in die Kammer während des Bearbeitens;

einer Umfangsbegrenzungslinien-Wafer-Dichteinrichtung zum Erzeugen einer Dichtung um den Wafer herum und zwischen dem Wafer und der CVD-Einspanneinrichtung; und

einer Gaszufuhreinrichtung zum Zuführen eines Inhibitionsgases durch die CVD-Einspanneinrichtung;

wobei die Umfangsbegrenzungslinien-Wafer-Dichteinrichtung aufweist:

einen Wafer-Dichtring zum Halten des Wafers gegen die CVD-Einspanneinrichtung; und

wobei der Wafer-Dichtring den Wafer ununterbrochen um den Außenumfang des Wafers herum berührt, auf der Seite des Wafers, die weg von der CVD-Einspannvorrichtung liegt, wobei ein Ringvolumen um den Wafer gebildet wird und wobei eine Dichtung nahe der Umfangsbegrenzungslinie mit der CVD-Einspanneinrichtung außerhalb der Umfangsbegrenzungslinie des Wafers gebildet wird, wobei die Gaszufuhreinrichtung dem Ringvolumen Inhibitionsgas zuführt.

9. System nach Anspruch 8, das weiterhin eine drehbare Nabe innerhalb der CVD-Kammer aufweist, wobei die CVD-Einspanneinrichtung an der drehbaren Nabe befestigt ist.

10. System nach Anspruch 8, das weiter aufweist:

eine Trägereinrichtung, die an dem Wafer-Dichtring befestigt ist, um den Wafer-Dichtring zu tragen und zu bewegen;

eine Führungseinrichtung, die an der Trägereinrichtung befestigt ist, um die Trägereinrichtung auf die CVD-Einspanneinrichtung zu und von ihr weg zu führen;

eine Antriebseinrichtung zum Vortreiben der Trägereinrichtung auf die CVD-Einspanneinrichtung zu und zum Zurückziehen der Trägereinrichtung von der CVD-Einspanneinrichtung; und

einer Druckeinrichtung, die der Trägereinrichtung zugeordnet ist, um den Wafer-Dichtring gegen den Wafer auf der CVD-Einspanneinrichtung zu drücken.

11. System nach Anspruch 8, bei dem die Dichtung in der Nähe der Umfangsbegrenzungslinie eine erste Fläche auf dem Dichtring und eine zweite Fläche auf der CVD-Einspanneinrichtung aufweist, wobei die erste Fläche in ihrer Form im wesentlichen der zweiten Fläche angepaßt ist und von der zweiten Fläche um einen Abstand X über eine radiale Länge Y getrennt ist, so daß der Abstand X multipliziert mit dem Volumenstrom des Inhibitionsgases in der nahe liegenden Dichtung einen Impuls für das Inhibitionsgas liefert, der größer ist als der Impuls für ein Beschichtungsgas in der entgegengesetzten Richtung während der Bearbeitung, und die radiale Länge Y gleich oder größer als das Zehnfache der mittleren freien Weglänge des Beschichtungsgases in der nahe liegenden Dichtung ist.

12. System nach Anspruch 11, bei dem erste Fläche und die zweite Fläche beide ebene Flächen sind.

## Revendications

1. Appareil pour empêcher le revêtement du bord et de la face arrière d'une tranche pendant un procédé de dépôt chimique en phase vapeur (CVD), comportant :

un moyen à mandrin CVD destiné à supporter une tranche pendant un procédé de dépôt ;

un moyen à bague d'étanchéité de la tranche destiné à maintenir ladite tranche contre ledit moyen à mandrin CVD, ledit moyen à bague d'étanchéité de la tranche étant en contact avec ladite tranche le long de la périphérie de ladite tranche sur la face de ladite tranche éloignée dudit moyen à mandrin CVD, formant un volume annulaire autour de ladite tranche, et formant un joint étanche à proximité du périmètre avec une surface dudit moyen à mandrin CVD à l'extérieur du périmètre de ladite tranche ; et

un moyen de distribution de gaz destiné à distribuer un gaz d'exclusion audit volume annulaire.

2. Appareil selon la revendication 1, comportant en outre un moyen de support relié à ladite bague d'étanchéité de la tranche pour supporter et déplacer ladite bague d'étanchéité de la tranche.

3. Appareil selon la revendication 2, comportant en outre :

un moyen de guidage relié audit moyen de support pour guider ledit moyen de support pendant qu'il se rapproche et s'éloigne dudit moyen à mandrin CVD ;

un moyen à actionneur pour faire avancer ledit moyen de support vers ledit moyen à mandrin CVD et rétracter ledit moyen de support dudit moyen à mandrin CVD ; et

un moyen de pression associé audit moyen de support pour appliquer sous pression ladite bague d'étanchéité de la tranche contre ladite tranche sur ledit moyen à mandrin CVD.

4. Appareil selon la revendication 1, dans lequel ledit joint d'étanchéité à proximité du périmètre présente une première surface sur ladite bague d'étanchéité et une seconde surface sur ledit moyen à mandrin CVD, ladite première surface épousant sensiblement la forme de ladite seconde surface et étant séparée de ladite seconde surface d'une distance X sur une longueur radiale Y telle que la distance X combinée avec le débit d'écoulement volumique dudit gaz d'exclusion dans ledit joint d'étanchéité de proximité produise une pulsation pour ledit gaz d'exclusion supérieure à la pulsation pour un gaz de dépôt dans le sens opposé pendant le traitement, et que ladite longueur radiale Y soit égale ou supérieure à 10 fois le libre parcours moyen du gaz de dépôt dans ledit joint d'étanchéité de proximité.

5. Appareil selon la revendication 4, dans lequel ladite première surface et ladite seconde surface sont toutes deux des surfaces plates.

6. Appareil selon la revendication 1, dans lequel lesdits moyens à mandrin CVD comportent un passage arrivant dans ledit volume annulaire, et dans lequel ledit moyen de distribution de gaz conduit ledit gaz d'exclusion dans ledit passage.

7. Procédé pour empêcher un dépôt chimique en phase vapeur (CVD) sur le bord et la face arrière d'une tranche pendant un traitement CVD, comprenant les étapes qui consistent :

à placer une bague d'étanchéité au-dessus de ladite tranche ;

à pousser ladite bague d'étanchéité contre ladite tranche pour presser la face arrière de ladite tranche contre un mandrin CVD, ladite bague d'étanchéité étant en contact avec la face avant de ladite tranche le long de la périphérie de ladite tranche, formant un joint d'étanchéité de proximité de périmètre avec ledit mandrin CVD, et formant un volume annulaire entre ladite bague d'étanchéité et ladite tranche ; et

à introduire directement un écoulement de gaz d'exclusion dans ledit volume annulaire.

8. Système pour mettre en oeuvre un procédé de dépôt chimique en phase vapeur (CVD) sur une tranche, comportant :

une chambre pour dépôt CVD ;

un moyen à mandrin CVD à l'intérieur de ladite chambre CVD, destiné à maintenir ladite tranche pendant le traitement ;

un moyen chauffant destiné à chauffer ladite tranche pendant le traitement ;

un moyen d'écoulement de gaz de traitement pour introduire des écoulements de gaz de traitement dans ladite chambre pendant le traitement ;

un moyen à joint d'étanchéité de périmètre de la tranche destiné à former un joint étanche autour de ladite tranche et entre ladite tranche et ledit moyen à mandrin CVD ; et

un moyen de distribution de gaz destiné à l'alimentation en un gaz d'exclusion à travers ledit moyen à mandrin CVD ;

ledit moyen à joint d'étanchéité de périmètre de la tranche comportant :

une bague d'étanchéité de tranche destinée à maintenir ladite tranche contre ledit moyen à mandrin CVD ; et

ladite bague d'étanchéité de tranche étant en contact avec ladite tranche de façon continue le long de la périphérie de ladite tranche sur la face de ladite tranche éloignée dudit moyen à mandrin CVD, formant un volume annulaire autour de ladite tranche, et formant un joint d'étanchéité de proximité de périmètre avec ledit moyen à mandrin CVD à l'extérieur du périmètre de ladite tranche, ledit moyen de distribution de gaz amenant un gaz d'exclusion audit volume annulaire.

9. Système selon la revendication 8, comportant en outre un moyeu tournant à l'intérieur de ladite chambre CVD, ledit moyen à mandrin CVD étant fixé audit moyeu tournant.

10. Système selon la revendication 8, comportant en outre :

un moyen de support relié à ladite bague d'étanchéité de la tranche pour supporter et déplacer ladite bague d'étanchéité de la tranche ;

un moyen de guidage relié audit moyen de support pour guider ledit moyen de support pendant qu'il se rapproche et s'éloigne dudit moyen à mandrin CVD ;

un moyen à actionneur destiné à faire avancer ledit moyen de support vers ledit moyen à mandrin CVD et à rétracter ledit moyen de support dudit moyen à mandrin CVD ; et

un moyen de pression associé audit moyen de support pour presser ladite bague d'étanchéité de la tranche contre ladite tranche sur ledit moyen CVD.

11. Système selon la revendication 8, dans lequel ledit joint d'étanchéité de proximité de périmètre présente une première surface sur ladite bague d'étanchéité et une seconde surface sur ledit moyen à mandrin CVD, ladite première surface épousant sensiblement la forme de ladite seconde surface et étant séparée de ladite seconde surface par une distance X sur une longueur radiale Y telles que la distance X combinée au débit d'écoulement volumique dudit gaz d'exclusion dans ledit joint d'étanchéité de proximité produise une pulsation pour ledit gaz d'exclusion supérieure à la pulsation d'un gaz de dépôt dans le sens opposé pendant le traitement, et que ladite longueur radiale Y soit égale ou supérieure à 10 fois le libre parcours moyen du gaz de dépôt dans ledit joint d'étanchéité de proximité.

12. Système selon la revendication 11, dans lequel ladite première surface et ladite seconde surface sont toutes deux des surfaces plates.

Fig. 1A

Fig. 1B

Fig. 1C

Fig. 1D

Process Optimization for Blanket Tungsten Process

Fig. 2

Fig. 3

EP 0 456 372 B1

17

Fig. 4

Fig. 5

Fig. 6

**Fig. 7**

**Wafer Temperature  Vs.  Argon Backside Flow**
**S/N  144**
**Pressure  =  6.5 Torr**

EP 0 456 372 B1

**Fig. 8**
**Wafer Temperature Vs. Argon Backside Flow**
**S/N 144**
**Pressure = 30 Torr**

22

Fig. 9

Wafer Temperature °C

Thermocouple Positions

✕ Bare Silicon Wafer, 1000 sccm Argon
◯ Bare Silicon Wafer, 500 sccm Argon
▢ Bare Silicon Wafer, No Backside Argon
● Tungsten Coated Silicon Wafer, 1000 sccm Argon
■ Tungsten Coated Silicon Wafer, 500 sccm Argon
▲ Tungsten Coated Silicon Wafer, No Backside Argon

## BASELINE 30 TORR PROCESS

Probe: 49 Points
Test Diameter: 4.92 Inches
Backside Flow: 300 sccm Argon
Substrate: TiW/Si

| Run # | Sheet Res. (mΩ/sq.) (6 Wafers) | Uniformity (1 s) (%) (6 Wafers) |
|---|---|---|
| 63 | 84 ± 5% | 2.8 ± 0.5 |
| 65 | 84 ± 5% | 2.7 ± 0.5 |
| 67 | 83 ± 5% | 2.8 ± 0.6 |
| 69 | 84 ± 5% | 2.7 ± 0.6 |
| 71 | 84 ± 5% | 2.8 ± 0.6 |
| 73 | 83 ± 5% | 3.0 ± 0.3 |
| 75 | 83 ± 5% | 3.1 ± 0.4 |
| 77 | 83 ± 5% | 3.0 ± 0.4 |
| Mean | 84mΩ/sq. ± 6% | 2.9 ± 0.5% |

In wafer uniformity : ± 2.9%　(one sigma)
wafer to wafer : ± 6%　(hi-lo/avg)
run to run : ± 0.5%　(hi-lo/avg)

NOTE : Reactor not optimized wafer-to-wafer

Fig. 10